**Europäisches Patentamt**

**European Patent Office**

**Office européen des brevets**

(19)

(11) Numéro de publication : **0 521 990 B1**

(12) ## FASCICULE DE BREVET EUROPEEN

(45) Date de publication du fascicule du brevet :
**14.12.94 Bulletin 94/50**

(51) Int. Cl.⁵ : **H01M 10/54,** G01N 27/72

(21) Numéro de dépôt : **91907019.3**

(22) Date de dépôt : **27.03.91**

(86) Numéro de dépôt international :
**PCT/EP91/00617**

(87) Numéro de publication internationale :
**WO 91/15036 03.10.91 Gazette 91/23**

(54) **DISPOSITIF ET PROCEDE DE MESURE POUR LE TRI DES PILES ET ACCUMULATEURS USAGES.**

(30) Priorité : **27.03.90 EP 90810247**

(43) Date de publication de la demande :
**13.01.93 Bulletin 93/02**

(45) Mention de la délivrance du brevet :
**14.12.94 Bulletin 94/50**

(84) Etats contractants désignés :
**AT BE CH DE DK ES FR GB GR IT LI NL SE**

(56) Documents cités :
**EP-A- 0 123 089**
**FR-A- 2 267 548**
**GB-A- 2 108 672**
**GB-A- 2 130 728**

(72) Inventeur : **TU XUAN, Mai**
**13, rue Chiésaz**
**CH-1024 Ecublens (CH)**
Inventeur : **NGUYEN, Trong, Thinh**
**165, route de Grand-Lancy**
**CH-1213 Onex (CH)**
Inventeur : **WIAUX, Jean, Pol**
**239, route d'Annecy**
**CH-1257 Croix-de-Rozon (CH)**
Inventeur : **SCHWAB, Michel**
**4, rue du Cornouiller**
**CH-2502 Bienne (CH)**

(74) Mandataire : **Cronin, Brian Harold John**
**42, rue Plantamour**
**CH-1201 Genève (CH)**

(73) Titulaire : **TITALYSE S.A.**
**7 rue Marcinhés**
**CH-1217 Meyrin (CH)**
Titulaire : **DETRA SA**
**35, Rue Scholl**
**CH-2504 Bienne (CH)**

EP 0 521 990 B1

## Description

Par leur commodité d'emploi, et aussi par l'expansion des appareils électriques ou électroniques portables, les piles ou les accumulateurs dits rechargeables ont aquis une place de choix dans la vie quotidien des ménages.

Ces piles ou accumulateurs sont des dispositifs de stockage et de conversion de l'énergie chimique en énergie électrique. En tenant compte de leurs contenus chimiques riches en métaux lourds, ces piles et accumulateurs présentent, à la fin de leur durée de vie, un inconvénient: ils sont indésirables dans les déchets urbains et nécessitent un traitement spécial pour retirer tous éléments toxiques.

Dans le domaine de traitement des piles et accumulateurs usagés, les procédés envisagés doivent faire face aux trois aspects caractéristiques du problème:

- Aspect quantitatif: le marché des piles et accumulateurs est en constante expansion. Aujourd'hui on estime que la nécessité de traitement s'élève à 100 tonnes de piles et accumulateurs par année et par millon d'habitants. A savoir qu'une tonne de piles ou accumulateurs représente en moyenne 20'000 à 22'000 unités. Cette capacité de traitement devrait être augmentée par un facteur 3 d'ici à l'an 2000.
- Aspect qualitatif: une récapitulation des teneurs en métaux lourds des différents piles et accumulateurs usuels, donnée ci-dessous, permet de visualiser la complexité de la nature chimique du problème de traitement.

| Type | Zn (%) | $MnO_2$ (%) | Hg (%) | Pb (%) | Cd (%) | Ag (%) | Ni (%) |
|---|---|---|---|---|---|---|---|
| Zinc-Carbone | 17 | 29 | 0.01 | 0.1 | 0.015 | – | – |
| Alcaline | 14 | 22 | 0.3 | 0.05 | – | – | – |
| Pile au mercure | 11 | – | 33 | – | – | – | – |
| Pile à l'argent | 10 | – | 1 | – | – | 10 | – |
| Pile Zn-Air | 30 | – | 1 | – | – | – | – |
| Accu. Ni-Cd | – | – | – | – | 15 | | 30 |

Sur le marché actuel, les piles Zinc-Carbone et alcalines présentent une part de 97%, les accumulateurs Ni-Cd varient entre 0.5 à 2%. Mais on attent à une augmentation de la part de ces derniers jusqu'à 5% dans 3 à 5 ans.

- Aspect de pureté: un procédé de traitement de piles et accumulateurs usagés n'est techniquement et économiquement envisageable que si les produits résultants peuvent être recyclés dans leurs circuits primaires. La valorisation de ces produits de recyclage est directement liée à leur degré de pureté.

Différents procédés de traitement des piles et accumulateurs usagés ont été mis au point. La technologie utilisée est soit par voie thermique, soit par voie humide par intermédiaire de la technique d'électrolyse. Cependant pour l'une ou l'autre technologie, la pureté minimale des produits recyclés ne peut être assurée qu'en absence, ou en présence d'une quantité minime, des éléments étrangers. Par exemple les procédés thermiques ou électrolytiques développés pour le recyclage des accumulateurs Ni-Cd ne tolère que 1% des éléments au zinc (piles alcalines ou Zinc-Carbone). Dans l'autre cas, le procédé thermique appliqué aux piles alcalines ou au Zinc-Carbone ne peut accepter que moins que 1% des accumulateurs au Cadmium.

Dans le problème de traitement des piles et accumulateurs usagés provenant du grand-public, une collect sélective selon la nature des piles ou accumulateurs est difficile, voire impossible, à envisager. Un procédé de tri de ces piles ou accumulateurs collectés devient alors une nécessité vitale pour les procédés de traitement subséquents.

La présente invention a pour objet un dispositif et un procédé d'analyse des piles ou accumulateurs usagés afin de permettre de les trier selon leur nature chimique. Le dispositif et le procédé accordés à cette invention permettent de trier les piles et accumulateurs usagés, quelques soit leur état et leur nature, d'une manière rapide, sure et économique.

Plusieurs possibilités sont envisageables pour déterminer la nature chimique d'une pile ou accumulateur usagé, par exemple la mesure de la spécifique. En effet, une pile au zinc-carbone possède une masse spécifique d'environ 1.9 g/cm$^3$, une pile alcaline (Zn-MnO$_2$) de 3.0 g/cm$^3$ et un accumulateur au Ni-Cd de 3.6 g/cm$^3$. Cete différence de masse spécifique, bien marquée dans le cas théorique, est malheureusement beaucoup plus faible en pratique, et dans certains cas ces valeurs sont complètement inversées. En effet, lorsqu'une pile ou un accumulateur usagé est stocké dans un endroit non protégé après une longue période, sa masse spécifique peut varier dans une large limite à cause des problèmes d'absorption de l'humidité, de fuite de l'électrolyte ou de corrosion. De ce fait, la mesure de la masse spécifique d'une pile ou un accumulateur n'est pas un moyen fiable pour déterminer sa nature chimique.

On peut aussi déterminer la nature d'une pile ou un accumulateur en analysant la nature des éléments contenus à l'intérieur. Cette analyse est possible par la méthode de fluorescence de rayon X. Ce procédé est relativement fiable mais onéreux et nécessite un temps de mesure assez long, ce qui le rend économiquement inapplicable.

Pour remédier aux inconvénients précités, la présente invention propose un dispositif et un procédé de déterminer la nature des piles ou accumulateurs usagés basé sur l'analyse des propriétés ferromagnétiques des éléments contenus dans la piles ou accumulateur.

L'invention sera mieux comprise à la lecture des la description qui va suivre, en se référant au dessin annexé dans lequel:

- Les figures 1.a, 1.b et 1.c représentent les coupes d'une pile au Zinc-carbone, d'une pile alcaline et d'un accumulateur au Ni-Cd.
- La figure 2 représente le dispositif de mesure selon l'invention.
- La figure 3 représente les courbes de réponse en tension électrique du dispositif de mesure de la figure 2.
- La figure 4 représente les courbes de réponse en fréquence du dispositif de mesure de la figure 2.

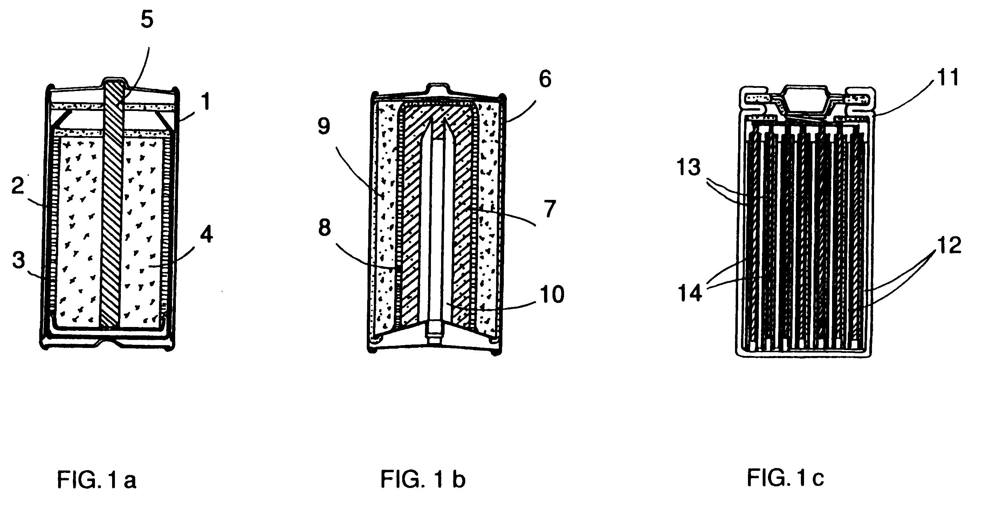

La figure 1.a représente la coupe d'une pile au Zinc-carbone montrant une enveloppe 1 en acier ou en plastique ou papier, une anode 2 en zinc, un séparateur 3 en matière plastique poreux, une masse cathodique 4 constituée de mélange de poudres d'oxide de manganèse et de carbone avec un électrolyte, un collecteur de courant cathodique 5 en graphite.

La figure 1.b représente la coupe d'une pile alcaline montrant une enveloppe 6 en acier, une masse anodique 7 constituée de mélange de poudre de zinc avec un électrolyte, un séparateur 8 en matière plastique poreux, une masse cathodique 9 constituée de mélange de poudres d'oxide de manganède et carbone avec un électrolyte, un collecteur de courant anodique 10 en laiton.

La figure 1.c représente la coupe d'un accumulateur au Ni-Cd montrant une enveloppe 11 en acier nickelé, les anodes 12 en forme de feuilles de cadmium enroulées, les séparateurs 13 en matières plastique poreux, les cathodes 14 en feuilles de nickel imprégnées de mélange de poudres d'oxyde de nickel et un électrolyte. On peut ainsi voir aisément que le contenu des piles à base de zinc (piles au Zinc-carbone et alcalines) est constitué par des éléments dits "non-ferromagnétique". Dans le cas d'un accumulateur au Ni-Cd, la propriété ferromagnétique du contenu est due à la présence des composants à base de nickel. Ainsi, y comprise la masse d'acier de l'enveloppe, la masse ferromagnétique des piles à base de zinc est très différente de celle des accumulateurs au Ni-Cd.

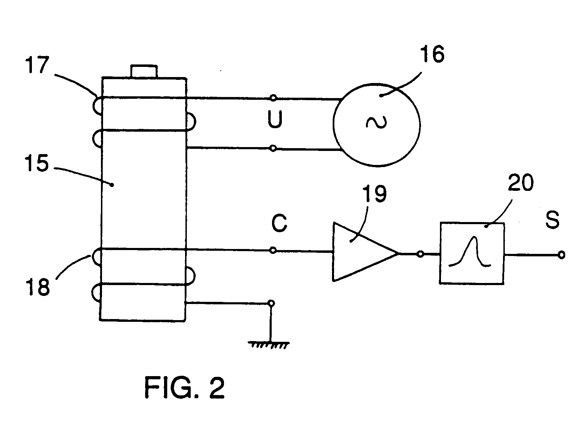

La figure 2 représente schématiquement un exemple de réalisation du dispositif de mesure selon l'invention. Le circuit d'excitation 17, alimenté par une source de tension variable 16, produit un flux variable traversant la masse de la pile ou l'accumulateur à analyser 15. Ce flux variable est capté par un capteur inductif 18 relié aux moyens de traitement 19 et 20. Le moyen de traitement 19 est composé d'un ou plusieurs amplificateurs de tension permettant d'adapter le niveau de tension C à la sortie du capteur inductif à la tension d'entrée F du moyen de traitement 20. Le moyen de traitement 20 est composé d'un ou plusieurs filtres actifs ou passifs permettant d'éliminer les interférences indésirables venant du capteur 18.

Ce dispositif de mesure fournit un signal S à la sortie des moyens de traitement dont l'amplitude est fonction de la masse ferromagnétique de la pile ou de l'accumulateur à analyser 15. L'analyse de l'amplitude du signal S permet donc de déterminer la nature chimique de la pile ou de l'accumulateur à analyser. Il est claire que la tension du signal S peut être codifiée par un traitement logiciel pour être utilisée comme commande d'un dispositif électro-pneumatique ou électro-mécanique, non représenté ici, qui sépare les piles ou accumulateurs selon leur nature accordant au signal S.

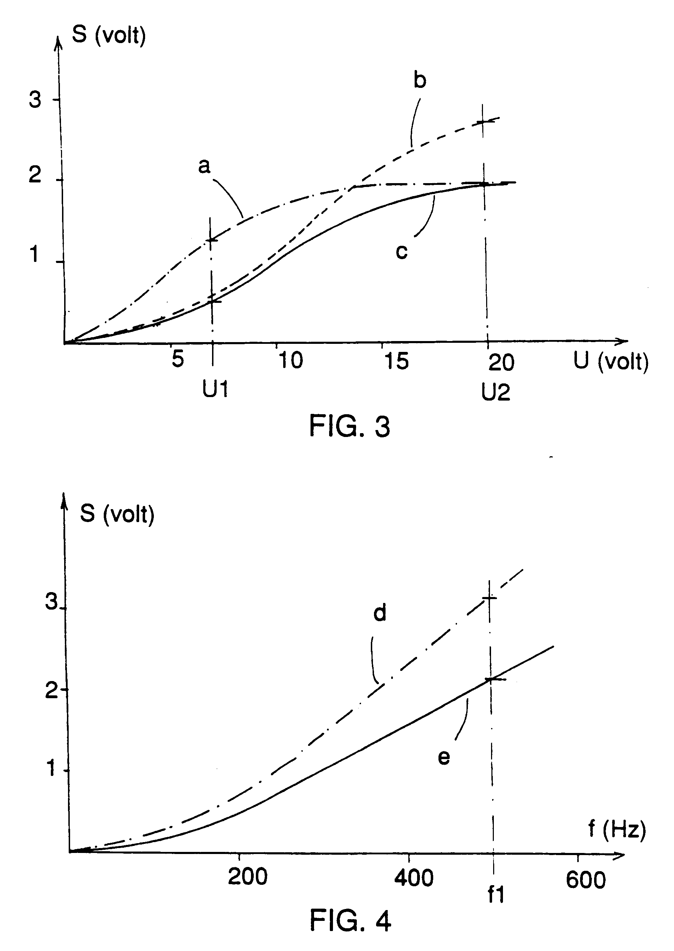

La figure 3 représente un exemple de l'amplitude du signal S en fonction de l'amplitude de la tension d'alimentation U du circuit d'excitation 17.

Dans cette figure la courbe a représente la réponse S d'une première pile alcaline (Zn-MnO$_2$), la courbe b celle d'une deuxième pile alcaline de marque différente et la courbe c la réponse d'un accumulateur au Ni-Cd.

En applicant une tension d'excitation U1 de l'ordre de 7 volts, la réponse S permet distiguer aisément la première pile alcaline de l'accumulateur au Ni-Cd. Par contre pour distinguer la deuxième pile alcaline de l'accumulateur au Ni-Cd, on doit appliquer une tension d'excitation U2 de l'ordre de 20 volts. Dans un tel cas, l'analyse n'est fiable que si le dispositif de mesure peut appliquer deux niveaux de tensions différents au circuit d'excitation 17.

La figure 4 représente la variation de l'amplitude du signal S en fonction de la fréquence f de la tention d'excitation U appliquée au circuit 17, dans ce cas la tension d'excitation U est maintenue constante à 10 volts. Dans cette figure la courbe d représente la réponse S d'une pile alcaline et la courbe e celle d'un accumulateur au Ni-Cd. On remarquera que la distintion entre la pile alcaline et l'accumulateur au Ni-Cd est possible en mesurant l'amplitude du signal S à une fréquence d'excitation f1 de l'ordre de 500 Hz.

Ces exemples montrent que pour augmenter la fiabilité de l'analyse, on peut combiner les courbes de réponse du signal S respectivement en fonction de la fréquence et de l'amplitude de la tension d'excitation. Il est possible dans ce cas d'inclure dans le dispositif de mesure deux ou plusieurs circuits d'excitation 17, et d'appliquer consécutivement à ces deux circuits d'excitation deux niveaux de tension U différents à deux fréquences différentes.

## Revendications

1. Dispositif de mesure des propriétés ferromagnétiques des piles ou accumulateurs usagés comprenant un circuit d'excitation (17), un capteur inductif (18) et des moyens de traitement (19, 20), lequel circuit d'excitation est composé d'une ou plusieurs bobines alimentée(s) par au moins une source de tension variable produisant un flux traversant la masse ferromagnétique de la pile ou de l'accumulateur à analyser (15) et couplé avec le capteur inductif (18), la (les) source(s) de tension étant agencée(s) pour appliquer au circuit d'excitation au moins deux amplitudes de tension différentes à une même fréquence et/ou au moins deux fréquences différentes pour une même amplitude de tension, lesdits moyens de traitement fournissant un signal de sortie en fonction de la nature et de la masse ferromagnétique de la pile ou de' l'accumulateur.

2. Dispositif de mesure selon la revendication 1, caractérisé en ce que ledit capteur inductif est constitué par une ou plusieurs bobines.

3. Dispositif de mesure selon la revendication 1, caractérisé en ce que ledit capteur inductif est constitué par des sondes à effet Hall.

4. Dispositif de mesure selon la revendication 1, caractérisé en ce que lesdits moyens de traitement possèdent au moins un amplificateur de tension (19) et/ou un filtre (20).

5. Appareil pour le tri des piles et accumulateurs usagés comprenant au moins un dispositif de tri des piles, commandé par le signal de sortie d'un dispositif de mesure selon l'une des revendications 1 à 4.

6. Procédé de mesure utilisant le dispositif de mesure selon l'une des revendications 1 à 4, caractérisé en ce que l'on applique au circuit d'excitation au moins deux amplitudes de tension différentes à une même fréquence.

7. Procédé de mesure utilisant le dispositif de mesure selon l'une des revendications 1 à 4, caractérisé en ce que l'on applique au circuit d'excitation au moins deux fréquences différentes pour une même amplitude de tension.

8. Procédé de tri des piles ou accumulateurs usagés utilisant le dispositif de mesure selon l'une des revendications 1 à 4 ou utilisant le procédé selon la revendication 6 ou 7, caractérisé en ce que le signal de sortie est codifié par un traitement logiciel pour servir de commande d'au moins un dispositif de tri des piles ou accumulateurs usagés.

## Patentansprüche

1. Vorrichtung zur Messung ferromagnetischer Eigenschaften verbrauchter Batterien oder Akkumulatoren, mit einer Erregerwicklung (17), einem Induktionsaufnehmer (18) und Verarbeitungseinrichtungen (19, 20), wobei die Erregerwicklung eine oder mehrere Spulen enthält, die durch mindestens eine veränderliche Spannungsquelle gespeist werden, wodurch ein Feld erzeugt wird, das durch den ferromagnetischen Körper der zu analysierenden Batterie oder Akkumulators (15) verläuft, und mit dem Induktionsaufnehmer (18) gekoppelt ist, wobei die Spannungsquelle(n) so ausgebildet ist (sind), um zumindest zwei verschiedene Spannungsamplituden gleicher Frequenz und/oder zumindest zwei verschiedenen Frequenzen gleicher Spannungsamplitude auf die Erregerwicklung zu bringen, wobei die Verarbeitungseinrichtungen ein Ausgangssignal als Funktion der Eigenschaft und des ferromagnetischen Körpers der Batterie oder des Akkumulators liefern.

2.  Meßvorrichtung nach Anspruch 1, **dadurch gekennzeichnet**, daß der Induktionsaufnehmer eine oder mehrere Spulen aufweist.

3.  Meßvorrichtung nach Anspruch 1, **dadurch gekennzeichnet**, daß der Induktionsaufnehmer eine Hall-Sonde aufweist.

4.  Meßvorrichtung nach Anspruch 1, **dadurch gekennzeichnet**, daß die Verarbeitungseinrichtungen zumindest einen Spannungsverstärker (19) und/oder einen Filter (20) aufweisen.

5.  Sortiergerät für verbrauchte Batterien und Akkumulatoren mit mindestens einer Batterie-Sortiervorrichtung, die durch das Ausgangs-Signal einer Meßvorrichtung nach einem der Ansprüche 1 bis 4 gesteuert wird.

6.  Meßverfahren unter Verwendung der Meßvorrichtung nach einem der Ansprüche 1 bis 4, **dadurch gekennzeichnet**, daß auf die Erregerwicklung mindestens zwei verschiedene Spannungsamplituden gleicher Frequenz gebracht werden.

7.  Meßverfahren unter Verwendung der Meßvorrichtung nach einem der Ansprüche 1 bis 4, **dadurch gekennzeichnet**, daß auf die Erregerwicklung mindestens zwei verschiedene Frequenzen gleicher Spannungsamplitude gebracht werden.

8.  Sortierverfahren für verbrauchte Batterien oder Akkumulatoren unter Verwendung der Meßvorrichtung nach einem der Ansprüche 1 bis 4 oder unter Verwendung des Verfahrens nach Anspruch 6 oder 7, **dadurch gekennzeichnet**, daß das Ausgangssignal durch eine Verarbeitungs-Logik kodiert wird, um den Befehl zumindest einer Sortiervorrichtung für verbrauchte Batterien oder Akkumulatoren zuzuführen.

## Claims

1.  A device for measuring the ferromagnetic properties of used batteries or accumulators, comprising an excitation circuit (17), an inductive sensor (18) and treatment means (19, 20), which excitation circuit is composed of one or more coils supplied by at least one variable voltage source producing a flux through the ferromagnetic mass of the battery or accumulator (15) to be analyzed and coupled with the inductive sensor (18), the voltage source(s) being arranged to apply to the excitation circuit at least two different amplitudes of voltage at the same frequency and/or one amplitude of voltage at two different frequencies, said treatment means supplying an output signal as a function of the constitution and of the ferromagnetic mass of the battery or accumulator.

2.  The measuring device of claim 1, characterised in that said inductive sensor is formed by one or more coils.

3.  The measuring device of claim 1, characterised in that said inductive sensor is formed by Hall-effect probes.

4.  The measuring device of claim 1, characterised in that said treatment means has at least one voltage amplifier (19) and/or at least one filter (20).

5.  An apparatus for sorting used batteries or accumulators comprising at least one battery sorting device controlled by the output signal of a measuring device according to one of claims 1 to 4.

6.  A measuring process using the measuring device according to one of claims 1 to 4, characterised by applying to the excitation circuit at least two different amplitudes of voltage at the same frequency.

7.  A measuring process using the measuring device according to one of claims 1 to 4, characterised by applying at least two different frequencies for the same amplitude of voltage.

8.  A process for sorting used batteries or accumulators using the measuring device according to one of claims 1 to 4, or using the process according to claim 6 or 7, characterised in that the output signal is codified by a computer program to serve for the control of at least one device for sorting used batteries or accumulators.

FIG. 1a

FIG. 1b

FIG. 1c

FIG. 2

FIG. 3

FIG. 4